(19) Europäisches Patentamt
European Patent Office
Office européen des brevets

(11) **EP 2 217 385 B1**

(12) **EUROPÄISCHE PATENTSCHRIFT**

(45) Veröffentlichungstag und Bekanntmachung des Hinweises auf die Patenterteilung:
**27.04.2011 Patentblatt 2011/17**

(21) Anmeldenummer: **08848572.7**

(22) Anmeldetag: **06.11.2008**

(51) Int Cl.:
*B05C 3/18* *(2006.01)*    *H01L 21/00* *(2006.01)*
*B05C 3/00* *(2006.01)*    *B05C 3/20* *(2006.01)*
*B05C 9/14* *(2006.01)*    *B05C 3/05* *(2006.01)*

(86) Internationale Anmeldenummer:
**PCT/EP2008/009379**

(87) Internationale Veröffentlichungsnummer:
**WO 2009/059770 (14.05.2009 Gazette 2009/20)**

(54) **VORRICHTUNG UND VERFAHREN ZUR BESCHICHTUNG EINER OBERFLÄCHE**

DEVICE AND METHOD FOR COATING A SURFACE

SYSTÈME ET PROCÉDÉ POUR APPLIQUER UN REVÊTEMENT SUR UNE SURFACE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: 07.11.2007 DE 102007053065
05.02.2008 DE 102008007570

(43) Veröffentlichungstag der Anmeldung:
**18.08.2010 Patentblatt 2010/33**

(60) Teilanmeldung:
**10163934.2 / 2 223 750**

(73) Patentinhaber: **Stangl Semiconductor Equipment AG**
**82223 Eichenau (DE)**

(72) Erfinder: **ECKSTEIN, Jens**
**85221 Dachau (DE)**

(74) Vertreter: **Stöckeler, Ferdinand**
**Schoppe, Zimmermann, Stöckeler & Zinkler**
**Patentanwälte**
**Postfach 246**
**82043 Pullach bei München (DE)**

(56) Entgegenhaltungen:
**EP-A- 0 038 084**    **EP-A- 0 608 192**
**EP-A- 1 428 581**    **GB-A- 1 206 106**
**US-A- 3 762 190**    **US-A- 3 863 600**
**US-A- 3 901 188**    **US-A- 5 795 625**
**US-A1- 2004 086 651**

**Beschreibung**

Ausführungsbeispiele der vorliegenden Erfindung befassen sich mit einer Vorrichtung und einem Verfahren zur Beschichtung einer Oberfläche eines Gutes.

Beschichtungen von Materialien werden beispielsweise im Bereich der Halbleitererzeugung und -strukturierung häufig durchgeführt. Dabei ist es oft erforderlich, eine Schichtdicke über die gesamte Fläche der zu beschichteten Oberfläche möglichst homogen einstellen zu können. Bei in einzelnen Stücken vorliegenden Elementen kann eine Beschichtung leicht erfolgen, wenn, beispielsweise, ein Wafer, eine Folie oder Glasscheibe beziehungsweise ein zu beschichtendes Gut in seiner Gesamtheit in ein zur Beschichtung geeignetes Volumen, welches zumindest teilweise mit dem Beschichtungsmaterial gefüllt ist, getaucht wird oder mit diesem einseitig oder beidseitig in Kontakt gebracht wird. Die Beschichtung selbst kann dabei durch unterschiedliche Mechanismen beschleunigt bzw. ausgelöst werden. So ist es beispielsweise denkbar, eine aktivierende Chemikalie erst zuzugeben, wenn die zu beschichtenden Oberfläche bereits mit dem Beschichtungsmaterial in Kontakt ist. Chemikalien, deren Reaktionszeit kurz ist, die also schnell reagieren, können beispielsweise erst im Reaktionsvolumen selbst oder unmittelbar vor dem Einbringen in dasselbe oder erst auf der Oberfläche des zu beschichtenden Gutes miteinander gemischt werden.

In einigen Bereichen der Beschichtungstechnik und der Halbleitertechnik ist es darüber hinaus erforderlich, große zusammenhängende Oberflächen zu beschichten. Dies kann beispielsweise bei biegsamen Substraten, wie sie u.a. bei der Herstellung von organischen Halbleitern eingesetzt werden können, der Fall sein. Auch auf dem Gebiet der Solartechnik, in dem die hohen Produktionskosten von Solarzellen die erzielbaren Erträge oft übersteigen, kann es wünschenswert sein, eine Technologie zur Verfügung zu stellen, die die Beschichtung von Folien, bandförmigen, Substraten oder Metallfolien ermöglicht, so dass in kurzer Zeit große Flächen beschichtet werden können, um so eine signifikante Reduzierung der Produktionskosten zu erreichen.

Die britische Patenmeldung 1206106 zeigt eine Einrichtung zum Beschichten von bandförmigem Material, bei der das Material über Transportrollen in einer Flüssigkeit geführt wird.

Die US Anmeldung 5,795,625 befasst sich als nächstliegender Stand der Technik ebenfalls mit einer Vorrichtung zur Beschichtung von Stoffen mit einer Flüssigkeit. Das zu beschichtende Material wird mittels einer Walze durch ein Tauchbecken geführt, welches über eine Leitung mit der zur Beschichtung verwendeten Flüssigkeit befüllt wird. Unterhalb des Beckens befindet sich ein Vorratsvolumen für Wasser, welches dazu verwendet werden kann, die zur Beschichtung verwendete Flüssigkeit auf konstanter Temperatur zu halten.

Die US Anmeldung 3,762,190 befasst sich mit einer Vorrichtung zur Behandlung von Ledermaterialien, die mittels Transportrollen durch ein Flüssigkeitsbad geführt werden. Dabei befindet sich das Leder vollständig im Flüssigkeitsbad und wird so von beiden Seiten mit dem zur Beschichtung verwendeten Material in Verbindung gebracht. Die Flüssigkeit kann beheizt werden.

Die europäische Patentanmeldung 0038084 schlägt vor, eine zu beschichtende Folie nach der Beschichtung zu kühlen, um eventuelle durch Hitze hervorgerufene Knicke in der Beschichtung zu verhindern.

Die europäische Patentanmeldung 0608192 A1 schlägt vor, eine zur Galvanisierung verwendete Flüssigkeit (Zink) auf eine Temperatur von 400 - 500° zu erhitzen.

Die US Anmeldung 3,863,600 schlägt vor, die zur Beschichtung einer Oberfläche eines bandförmigen Materials verwendete Beschichtungslösung in einem externen Kreislauf zu temperierten.

Es besteht somit die Notwendigkeit, alternative und effizientere Konzepte zu entwickeln, um die Oberfläche eines Gutes zu beschichten.

Bei Ausführungsbeispielen der vorliegenden Erfindung wird es ermöglicht, eine Oberfläche eines Gutes zu beschichten, indem eine Transporteinrichtung verwendet wird, die die zu beschichtende Oberfläche des Gutes mit einer Flüssigkeit, welche die zur Beschichtung erforderlichen Reagenzien aufweist, in Kontakt bringt und an der Oberfläche vorbeiführt. Durch Variationen der Operationsparameter der Transporteinrichtung, wie beispielsweise des Vorschubs pro Zeiteinheit, kann erreicht werden, dass die zu beschichtende Oberfläche für eine vorbestimmte Zeit mit der Flüssigkeit in Kontakt bleibt, um eine Beschichtung derselben zu bewirken.

Durch Variation der Reaktionsparameter wie beispielsweise der Temperatur und der Konzentration der Reagenzien kann die Reaktionsgeschwindigkeit und in Kombination damit durch Variation der Kontaktzeit zwischen Material und Flüssigkeit die Schichtdicke der Beschichtung frei variiert werden. Die Variation der Kontaktzeit kann dabei bei einigen Ausführungsbeispielen von Transporteinrichtungen durch einfache Einstellung der Operationsparameter derselben erreicht werden.

Bei Ausführungsbeispielen der Erfindung wird zusätzlich das Gut von der Transporteinrichtung kontinuierlich und ohne Umkehr der Bewegungsrichtung an der Flüssigkeit vorbeigeführt bzw. durch ein Flüssigkeitsvolumen geleitet, so dass es möglich ist, kontinuierlich und ohne Unterbrechung die Beschichtung von ausgedehnten, beispielsweise bandförmigen, Materialien bzw. Gütern durchzuführen.

Bei weiteren Ausführungsbeispielen bzw. Systemen zur Beschichtung werden diese Materialien von einer Vorratsrolle zur Verfügung gestellt bzw. abgewickelt, um nach Beschichtung mittels der Transporteinrichtung bzw. nach Durchlauf der Transporteinrichtung auf einer Entnahmerolle empfangen und aufgerollt zu werden. Dies ermöglicht es, effizient und ohne Unterbrechung große Flächen bahnförmigen Materials zu beschichten.

Weitere Ausführungsbeispiele weisen eine Trockeneinrichtung auf, um das beschichtete Gut zu trocknen, so dass die Flüssigkeit der Beschichtung vollständig getrocknet ist, bevor das beschichtete Gut entnommen oder auf eine Entnahmerolle aufgewickelt wird, so dass die Qualität der Beschichtung nicht nach dem eigentlichen Beschichtungsvorgang durch etwaige mechanische Einflüsse verschlechtert wird. Die Ausführungsbeispiele der Erfindung weisen eine Heizeinrichtung auf, um die Oberfläche des zu beschichtenden Gutes und/oder die Flüssigkeit mit eventuellen chemischen Reagenzien zu heizen, so dass eine endotherme Reaktion ermöglicht wird oder um die Reaktionsgeschwindigkeit zu variieren. Dies erlaubt es beispielsweise, eine die Beschichtung auslösende bzw. das Beschichtungsmaterial bildende chemische Reaktion erst in unmittelbarem Kontakt mit der Oberfläche zu ermöglichen oder eine Reaktionsgeschwindigkeit derart zu erhöhen, dass eine durch die Beschichtung zu erzielende Schichtdicke bei gegebener Transporteinrichtung, also bei gegebener Vorschubgeschwindigkeit bzw. Relativgeschwindigkeit zwischen der Oberfläche des Gutes und der Flüssigkeit, erzielt wird.

Bei einigen Ausführungsbeispielen wird das zu transportierende Gut mittels einer zylindrischen Walze durch ein Flüssigkeitsbad geführt, wobei die Walze beheizt ist. Dabei kann die Geometrie der Transporteinrichtung so gewählt sein, dass das Gut entweder erfindungsgemäß einseitig oder nicht erfindungsgemäß beidseitig beschichtet wird, d.h. also einseitig oder beidseitig mit der Flüssigkeit in Kontakt gerät. Bei weiteren Ausführungsbeispielen ist die Transporteinrichtung mit Dichtmitteln versehen, die es ermöglichen, denjenigen Oberflächenbereich des Gutes, der mit der Flüssigkeit in Kontakt gebracht wird, räumlich zu begrenzen. Dies können beispielsweise Dichtlippen sein, die am Rand eines bandförmigen Materials das Material gegenüber der Flüssigkeit abdichten, so dass es nur in einem zentralen, um die Symmetrieachse des Bandeszentrierten Bereichs zu einer Beschichtung des Materials bzw. des Gutes kommt.

Bei einigen weiteren Ausführungsbeispielen der Erfindung sind Transportrollen, die das Gut nach der Beschichtung bzw. nach der Transporteinrichtung führen, so konstruiert, dass diese einen Wasserfilm auf der Oberfläche der Transportrolle erzeugen, so dass eventuell noch nicht vollständig getrocknetes bzw. ausgehärtetes Beschichtungsmaterial durch die Transportrolle nicht von der Oberfläche des zu beschichtenden Gutes entfernt wird oder die Beschichtung beschädigt wird. Der Wasserstrom kann bei einigen Ausführungsbeispielen darüber hinaus dazu erwendet werden, eventuell vorhandene Verunreinigungen von der Oberfläche des beschichteten Guts zu spülen und dabei eventuell gleichzeitig einen berührungslosen Transport ermöglichen.

Einige Ausführungsbeispiele der Erfindung werden nachfolgend, Bezug nehmend auf die beiliegenden Figuren, näher erläutert. Es zeigen:

Fig. 1 ein Ausführungsbeispiel einer Vorrichtung zur Beschichtung einer Oberfläche eines Guts;

Fig. 2 ein weiteres Ausführungsbeispiel einer Vor- richtung zur Beschichtung einer Oberfläche;

Fig. 3 ein weiteres Ausführungsbeispiel einer Vor- richtung zur Beschichtung einer Oberfläche mit Recyclingkreislauf;

Fig. 4a-4c ein Ausführungsbeispiel zur einseitigen Be- schichtung eines abgegrenzten Oberflächenbe- reichs eines bandförmigen Gutes;

Fig. 5a, 5b ein nicht erfindungsgemäßes Ausführungsbeispiel zur Be- schichtung einer Oberfläche mit linearem Vorschub des zu transportierenden Gutes;

Fig. 6 ein nicht erfindungsgemäßes Ausführungsbeispiel einer Vor- richtung zur Beschichtung einer Oberfläche mit linearem Vorschub;

Fig. 7 ein nicht erfindungsgemäßes Ausführungsbeispiel mit linea- rem Vorschub und Heizmöglichkeit;

Fig. 8 ein nicht erfindungsgemäßes Ausführungsbeispiel mit linea- rem Vorschub und Dichtmitteln zur Begrenzung des beschichteten Oberflächenbereichs;

Fig. 9 ein nicht erfindungsgemäßes Ausführungsbeispiel mit linea- rem Vorschub;

Fig. 10 ein nicht erfindungsgemäßes Ausführungsbeispiel mit linea- rem Vorschub zur beidseitigen Beschichtung eines Gutes;

Fig. 11 ein nicht erfindungsgemäßes Ausführungsbeispiel zur beid- seitigen Beschichtung;

Fig. 12 ein Ausführungsbeispiel eines erfindungsgemäßen verfahrens zur Beschichtung einer Oberfläche eines Gutes;

Fig. 13 ein Ausführungsbeispiel eines erfindungsgemäßen Systems zum Beschichten eines bahnförmigen Gutes; und

Fig. 14a, b ein nicht erfindungsgemäßes Ausführungsbeispiel mit band- förmigem zu beschichtendem Gut.

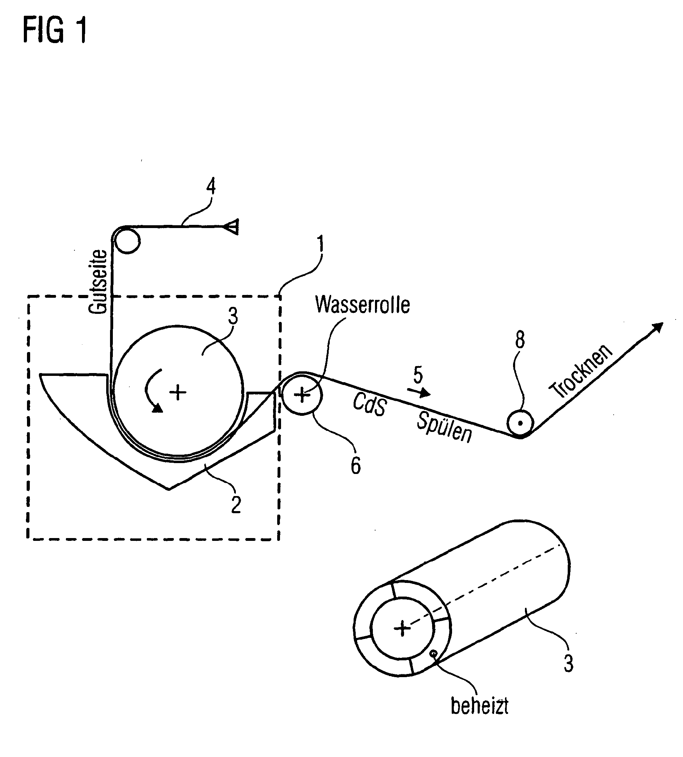

Fig. 1 zeigt ein Ausführungsbeispiel einer Vorrichtung zur Beschichtung einer Oberfläche eines Gutes, das geeignet ist, bahnförmiges Material zu beschichten.

In Fig. 1 ist die Vorrichtung schematisch in einer Schnittansicht dargestellt. Die Vorrichtung 1 weist dabei eine Transporteinrichtung 3 auf, um die zu beschichtende Oberfläche eines Gutes 4 (beispielsweise eines Materialbands) mit einer Flüssigkeit in Kontakt zu bringen und an der Flüssigkeit vorbei zu führen. Die Vorrichtung umfasst ferner einen Behälter 2, in dem sich die bereitgestellte Flüssigkeit befindet und eine Transportrolle 3, mittels derer das zu beschichtende Gut an der Flüssigkeit innerhalb des Behälters 2 vorbeigeführt wird. Im in Fig. 1 gezeigten Fall ist das zu beschichtende Gut 4 bandförmig, besitzt in einer Transportrichtung 5 also eine geometrische Ausdehnung, die die Ausdehnung des Bandes senkrecht zur Transportrichtung (die Breite des Bandes) bei weitem übersteigt. Das zu beschichtende Gut 4 kann dabei beispielsweise von einer Rolle mittels eines Abwicklers gewonnen und der Transporteinrichtung 3 zugeführt werden, wobei die zu beschichtende Oberfläche (die Gutseite) auf der der Transportrolle 3 abgewandten Seite befindlich ist. Durch eine Rotation der Transportrolle 3 (der Transporteinrichtung) wird das Gut 4 an der Flüssigkeit vorbeigeführt, bzw. durch das Flüssigkeitsvolumen, welches sich innerhalb des Behälters 2 befindet, transportiert.

Somit wird von der Transporteinrichtung 3 das zu beschichtende Gut 4 tangential zu der zu beschichtenden Oberfläche (der Gutseite) kontinuierlich bewegt, ohne dass eine Umkehr der Bewegungsrichtung stattfindet. Dies hat den Vorteil, dass das Material beschichtet werden kann, ohne den Vorschub des Gutes zu unterbrechen, so dass beispielsweise eine Rolle-zu-Rolle-Beschichtung von bandförmigen bzw. flexiblen Materialien wie beispielsweise Folien oder Metallbändern, ermöglicht wird.

Im in Fig. 1 gezeigten Fall wird das Gut in Transportrichtung 5 transportiert, so dass dieses beispielsweise einem nachfolgenden Aufwickler zugeführt werden kann, der das beschichtete Gut entgegennimmt und in Rollenform aufwickelt. Im Ausführungsbeispiel von Fig. 1 schließt sich an die Transporteinrichtung 1 ferner eine erste Umlenkrolle 6 und eine zweite Umlenkrolle 8 an, die dazu dienen, das bandförmige Gut zu führen. Bei einigen Ausführungsbeispielen kann die erste und/oder die zweite Umlenkrolle 6 oder 8 ausgebildet sein, um einen Wasserfilm auf der Oberfläche der Rolle bereitzustellen. Dies kann beispielsweise dadurch geschehen, dass die Führungsrolle eine zentrale Bohrung aufweist, in die Wasser mit vorbestimmtem Druck geleitet wird, so dass dieses durch eine Vielzahl von radialen Bohrungen in der Führungsrolle 6 auf den Außenumfang der Führungsrolle 6 strömt und dort zwischen dem zu transportierenden Gut 4 und der Führungsrolle 6 einen Wasserfilm bildet, welcher verhindert, dass die zu beschichtende Oberfläche des Gutes in unmittelbaren mechanischen Kontakt mit metallischen oder festen Teilen der Führungsrolle 6 kommen kann. Dies hat den Vorteil, dass, selbst wenn eine chemische Reaktion bzw. eine Beschichtungsreaktion oder ein Aushärten des zur Beschichtung verwendeten Materials bzw. der Flüssigkeit noch nicht vollständig erfolgt ist, eine qualitative Verschlechterung der Beschichtung durch mechanischen Kontakt mit starren oder festen Körpern verhindert werden kann.

Dabei ist zu bemerken, dass die Beschichtung von Folien oder Metallen oder ähnlichen bandförmigen Materialien mittels des in Figur 1 gezeigten Ausführungsbeispiels sowohl erfindungsgemäß einseitig als auch nicht erfindungsgemäß zweiseitig möglich ist, je nachdem, ob das Gut 4 fluidisch dicht auf der Transportrolle 3 aufliegt, bzw. ob zwischen dem bandförmigen Gut 4 und der Transportrolle 3 Abdichtungsmaßnahmen getroffen sind, die verhindern, dass die Flüssigkeit auch auf die der zu beschichtenden Seite (der Gutseite) des Materials gegenüberliegenden Seite gelangen kann. Bezüglich der Materialeigenschaften des zu beschichtenden Gutes gibt es keine Einschränkungen. So kann eine zu beschichtende Folie bzw. ein bandförmiges Material beispielsweise aus Kunststoff, aus magnetischem oder nichtmagnetischem Material bestehen.

Im Falle einer einseitigen Beschichtung ist bei einigen Ausführungsbeispielen die erste Führungsrolle 6 ausgebildet, um einen Wasserfilm auf ihrer Oberfläche zu erzeugen, so dass die beschichtete Gutseite der Oberfläche nicht beschädigt wird. Wird das Material bzw. das Gut 4 nicht erfindungsgemäß beidseitig beschichtet, kann bei einigen Ausführungsbeispielen auch die zweite Führungsrolle 8 ausgebildet sein, um das Gut bzw. das Material auf einem Wasserfilm zu führen.

Bei einigen Ausführungsbeispielen wird die Vorschubgeschwindigkeit bzw. die Geschwindigkeit, mit der das Gut an der Flüssigkeit vorbei bewegt wird, derart eingestellt, dass sich die gewünschte Beschichtungsstärke ergibt. Dies kann sowohl durch vorher festgelegtes Design als auch durch eine Regelung erfolgen, so dass beispielsweise, wenn nach der Beschichtung festgestellt wird, dass die Schichtdicke zu gering ist, die Geschwindigkeit des Transports verringert werden kann. Bei einigen Ausführungsbeispielen wird dir Flüssigkeit im Gegenstrom zum zu beschichtenden Gut gefördert oder zirkuliert, das heißt also entgegen der Bewegungsrichtung des Guts. In diesem Fall ist gewährleistet, dass das Medium an der Kontaktstelle immer frisch ist.

Durch die Variation der Geschwindigkeit wird also die vorbestimmte Zeit, in der die Flüssigkeit mit der zu beschichteten Oberfläche des Gutes in Kontakt kommt, variiert. Bei einigen weiteren Ausführungsbeispielen kann entweder die Transportrolle 3 oder die Flüssigkeit bzw. der Behälter 2 oder beide im vorhergehenden genannten Einrichtungen beheizt sein, so dass eine Reaktionsgeschwindigkeit einer Chemikalie, die zur Beschichtung verwendet wird, erhöht wird oder dass eine endotherme Reaktion ermöglicht wird.

Eine geeignete Abstimmung der Temperatur bzw. der Transportgeschwindigkeit erlaubt es, die erzielbaren Schichtdicken zu wählen oder die Beschichtungsgeschwindigkeit geeignet einzustellen. Ein Beispiel für die erfindungsgemäße Beheizung der Transportrolle 3 ist in Fig. 1 unten in der perspektivischen Ansicht einer Transportrolle 3 gezeigt, die in Form eines Hohlzylinders ausgebildet ist, durch dessen Inneres eine zur Beheizung verwendete Flüssigkeit strömen kann. Dies kann beispielsweise ein Öl oder auch Wasser sein, wobei bei einigen Ausführungsbeispielen eine Flüssigkeit mit hoher Wärmekapazität verwendet wird, um eine gleichmäßige Beheizung sicherzustellen.

Sofern für die Beschichtung bzw. die chemische Reaktion, die an der Oberfläche des zu beschichtenden Gutes stattfinden soll, eine maximale Relativgeschwindigkeit zwischen dem zu beschichtenden Gut und der Flüssigkeit nicht überschritten werden darf, da die zur Beschichtung verwendeten Partikel sonst beispielsweise nicht mehr an der Oberfläche haften können, kann bei konstanter Rotationsgeschwindigkeit der Umfang der Transportrolle 3 variiert werden, bzw. die Rotationsgeschwindigkeit kann bei konstantem Umfang verringert werden. Um einen guten Austausch der Flüssigkeit zu gewährleisten, wird bei einigen Ausführungsbeispielen die Flüssigkeit entgegen der Rotationsrichtung gefördert werden.

Zusätzlich zu den vorhergehend beschriebenen Heizmaßnahmen kann die Transportrolle 3 bei einigen Ausführungsbeispielen auch elektrisch beheizt sein. Ferner kann die Rolle oder das Gut auch mittels Strahlung beheizt werden, beispielsweise mittels Infrarotstrahlung. Das Material der Transportrolle 3 kann je nach zu transportierendem Gut oder gewünschter Wärmekapazität variiert werden. Beispielsweise können Metalle oder Metalllegierungen, Gläser oder Kristalline Substanzen verwendet werden.

Wie bereits oben erwähnt, lässt sich durch geeignete Anpassung des Durchmessers der Trommel oder Rolle und der Rotationsgeschwindigkeit das System auf die jeweils gegebenen Randbedingungen anpassen. Dies führt bei nicht erfindungsgemäßen Ausführungsbeispielen auch dann zum Erfolg, wenn die Trommel nicht rotiert, sondern lediglich zur Definition des Weges des Gutes dient. Die kann beispielsweise der Fall sein, wenn das Gut über die Trommel 3 gleitet oder auf dieser auf einem Luft- oder Flüssigkeitskissen schwimmt.

Ist beispielsweise eine maximale Relativgeschwindigkeit zwischen zu beschichtendem Gut und Flüssigkeit von 1 mm/s vorgegeben und soll die gesamte Beschichtungsdauer 7 Minuten betragen, lässt sich der Trommeldurchmesser wie folgt abschätzen. Dabei wird als Arbeitshypothese davon ausgegangen, dass der Flüssigkeitsstand innerhalb des Behälters 2 so gewählt ist, dass 40% des Umfangs der Transportrolle 3 innerhalb der Flüssigkeit befindlich sind. Bei angenommener Relativgeschwindigkeit von 1 mm/s und 7 Minuten Beschichtungsdauer ergibt sich ein innerhalb der Flüssigkeit zurückzulegender Weg von 420 mm. Darüber hinaus ergibt sich aus der Tangentialgeschwindigkeit von 1 mm/s und dem wie folgt zu berechnenden Durchmesser der Trommel unmittelbar die Rotationsfrequenz derselben. Der Umfang der Trommel, der innerhalb der Flüssigkeit befindlich ist, muss 420 mm betragen. Da für den Radius r der Trommel gilt:

$$r = \frac{U}{2 \cdot \pi}$$

und darüber hinaus 40% des Umfangs 420 mm entsprechen (daraus ergibt sich für den vollen Umfang eine Länge von 1.050 mm), ergibt sich der erforderliche Radius der Transportrolle 3 zu:

$$r = \frac{1.050\,mm}{2 \cdot \pi} = 167\,mm$$

Eine Trommel eines Durchmessers von 334 mm erfüllt also die eingangs geforderten Bedingungen, wobei sich diese mit einer Frequenz dreht, die unmittelbar durch die maximale Relativgeschwindigkeit von 1 mm/s und dem Radius der Trommel vorgegeben ist.

Wird eine Relativgeschwindigkeit von 2 mm/s bei einer Beschichtungsdauer von 7 Minuten gefordert, würde sich durch Anwendung obiger Überlegungen eine Trommel doppelten Durchmessers, also mit d = 668 mm ergeben. Bei einer solchen Relativgeschwindigkeit würde sich eine Relativgeschwindigkeit von 120 mm/min ergeben. Folglich werden innerhalb der Flüssigkeit bzw. im Kontakt mit der Flüssigkeit in 7 Minuten Beschichtungszeit 840 mm Weg zurück gelegt, was mittels einer Trommel obiger Dimensionierung erreicht werden kann.

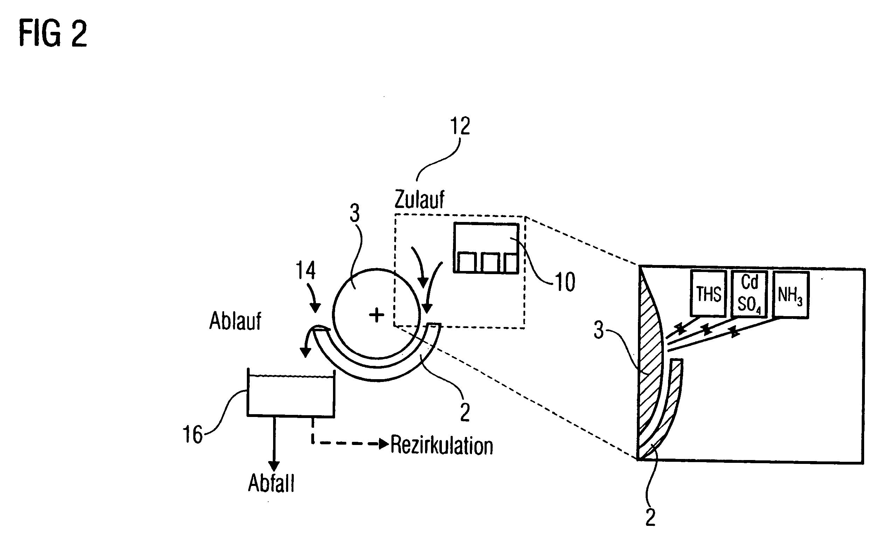

Figur 2 zeigt ein weiteres Ausführungsbeispiel einer Vorrichtung zur Beschichtung einer Oberfläche, wobei schematisch zusätzlich ein Mischer 10 gezeigt ist, der der Einrichtung zum Bereitstellen der Flüssigkeit (also dem Behälter 2) an einer Einbringposition 12 die Flüssigkeit bzw. die Chemikalien zuführt. An einer Ausbringposition 14, die in Form eines Überlaufs ausgebildet ist, verlässt die Flüssigkeit den Behälter 2, um in einem Auffangbehältnis 16 gesammelt zu werden. Die Flüssigkeit innerhalb des Auffangbehältnisses 16 kann dabei gemäß einer Alternative als Abfall behandelt werden oder, wie es weiter unten noch näher ausgeführt wird, einer Rezirkulation zugeführt werden.

Der Mischer 10 kann beispielsweise eine Flüssigkeit, die aus mehreren Reagenzien besteht, im bereits vorgemischten Zustand bevorraten, um diese mit vorbestimmter Dosierungsgeschwindigkeit bzw. Menge dem Zulauf, also der Einbringposition 12 zuzuführen. Bei anderen Ausführungsbeispielen, bei denen eine möglicherweise vorzeitig stattfindende Reaktion der Reagenzien in der Flüssigkeit unerwünscht ist, kann der Mischer 10 die einzelnen Reagenzien getrennt bevorraten und erst unmittelbar vor der Zuführung zu der Einbringposition 12 mischen. Die Mischung kann prinzipiell auch innerhalb des Behälters 2 erfolgen, so dass bei weiteren Ausführungsbeispielen der Mischer 10 die einzelnen Reagenzien getrennt der Einbringposition zuführt. Soll beispielsweise eine Folie oder ein bandförmiges Material mit CdS, ZnS oder alternativen Materialien (Puffern) beschichtet werden, wie es bei der Produktion von Dünnschichtsolarzellen wünschenswert ist, können folgende Reagenzien in der Flüssigkeit enthalten sein: $CdSO_4$, THS und $NH_3$. Diese reagieren oberhalb einer Reaktionstemperatur chemisch, so dass sich auf der Oberfläche des Gutes 4 eine Schicht aus CdS abscheidet. Für die genannten chemikalischen Komponenten beträgt diese Reaktionstemperatur 53°C.

Um eine vorzeitige Reaktion und somit einen unnötigen Chemikalienverbrauch zu verhindern, können diese Chemikalien getrennt bevorratet werden, wobei die Bevorratung dann sowohl oberhalb der Reaktionstemperatur von 53°C als auch unterhalb derselben stattfinden kann. Wird die Bevorratung unterhalb der Reaktionstemperatur vorgenommen, können bei einigen Ausführungsbeispielen die Reagenzien auch bereits vermischt sein. Auch können Teile bereits vorgemischt bevorratet werden, beispielsweise $CdSO_4$ und $NH_3$, wobei deren Bevorratung kalt oder warm erfolgen kann, sofern THS getrennt zugegeben und dosiert wird.

Erfindungsgemäß ist zusätzlich, wie oben beschrieben, die Transportrolle 3 beheizt um eine Reaktion insbesondere an der Oberfläche der Transportrolle hervorzurufen. Dies kann zu einer Reduktion des Chemikalienverbrauchs führen, wenn im übrigen Volumen eine Reaktion der Chemikalien nicht oder nur mit verringerter Geschwindigkeit stattfindet, da die Reaktionstemperatur lediglich in unmittelbarer Umgebung der Rolle überschritten wird.

In der in Figur 2 gezeigten Ausschnittsvergrößerung ist erneut schematisch die Möglichkeit der Einzeldosierung dargestellt, bei der die unterschiedlichen Chemikalien (im illustrierten Beispiel THS, $CdSO_4$ und $NH_3$) einzeln bevorratet und der Einbringposition 12 zugeführt werden.

Wie es in der Ausschnittsvergrößerung zu sehen ist, werden die Chemikalien einzeln bevorratet und über geeignete Dosiermethoden an der Einbringposition 12 in den Behälter 2 gegeben. Die Förderung der Chemikalien bzw. Flüssigkeiten kann beispielsweise mittels Flügelrad- oder Dosierpumpen vorgenommen werden. Alternativ kann der Tank auch unter Druck gesetzt sein, so dass mittels getaktetem Öffnen und Schließen eines Ventils eine dosierte Förderung erfolgt. Im Förderweg bzw. vor der Einbringposition 12 kann ferner ein Mischer angebracht sein, der beispielsweise unter dem Einfluss der Schwerkraft, die einzelnen Komponenten mischt. Alternativ kann die Chemikalienzufuhr mittels eines Schwimmers geregelt werden, der die Menge der aus dem.Vorratsbehältnis entfernte Flüssigkeit bestimmt, so dass diese prinzipiell auch unter dem Einfluss der Schwerkraft entnommen werden kann, sofern ein Ventil durch den Schwimmerstand geregelt wird.

Durch den geringen Chemikalienverbrauch lässt sich auch die Chemikalie im Spalt selbst unmittelbar nach dem Eintritt in den (Reaktor-) Spalt auf Prozesstemperatur heizen.

Bei dem in Figur 2 gezeigten Ausführungsbeispiel ist der Behälter 2 derart geformt, dass dieser eine innere Oberfläche aufweist, die der zu beschichtenden Oberfläche des Gutes 4 gegenüberliegt und deren Kontur an die Kontur der zu beschichtenden Oberfläche angepasst ist. Im dargestellten Fall ist also die innere Kontur des Behälters 2 kreisbogenförmig, so dass sich zwischen Transportrolle 3 und Innenwand des Behälters ein Spalt konstanter Breite ergibt. Eine geringe Breite dieses Spalts führt dazu, dass lediglich eine geringe gemischte Chemikalienmenge vorgehalten werden muss. Dies führt dazu, dass der Ausschuss, der proportional zum Volumen der bereits gemischten Chemikalie ist, minimiert werden kann. Darüber hinaus lässt sich das geringe Flüssigkeitsvolumen einfach beheizen, so dass ggfs. lediglich eine Beheizung der Transportrolle 3 erforderlich ist. Das Volumen, in dem die chemische Reaktion stattfindet, wird allgemein auch als Reaktor bezeichnet. Wird das Reaktorvolumen so weit wie möglich minimiert, führt dies, zusammengefasst, also dazu, dass lediglich ein geringer Medienverbrauch stattfindet, wobei das Medium zusätzlich nur wenig auskühlt, so dass in dem Spalt die Reaktor-Reaktion (die Spaltreaktion) effizient stattfinden kann.

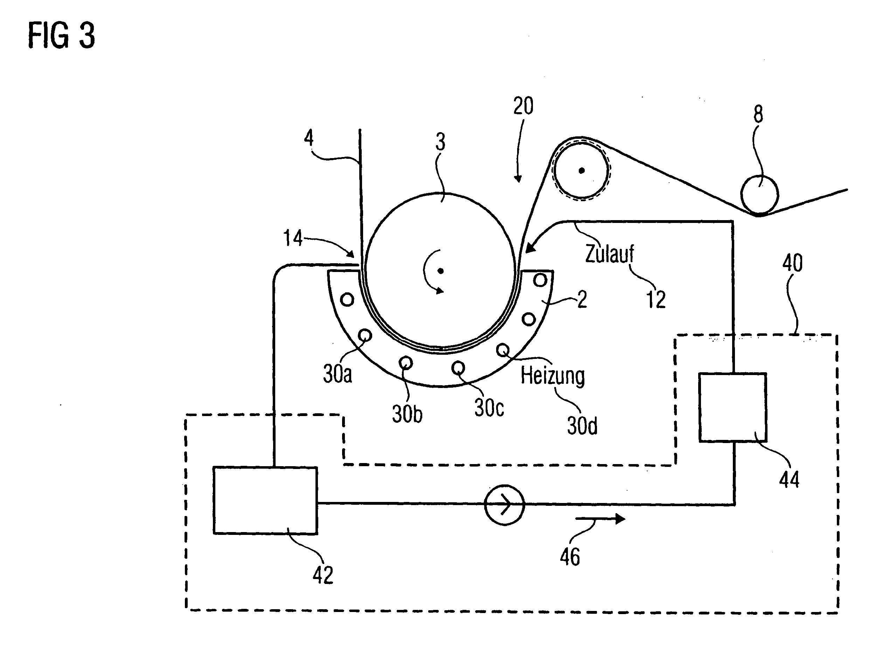

Figur 3 zeigt ein weiteres Ausführungsbeispiel einer Vorrichtung zum Beschichten einer Oberfläche, in dem die Reaktion bzw. die Beschichtung in einem Spalt 20 zwischen dem zu beschichtenden Gut 4 und einer Kontur des Behälters 2 stattfindet. Die übrigen skizzierten Komponenten der Vorrichtung wurden bereits anhand von vorhergehenden Ausführungsbeispielen diskutiert, so dass die mit denselben Bezugszeichen versehenen Elemente aus Effizienzgründen im Folgenden nicht erläutert werden. Das in Figur 3 gezeigte Ausführungsbeispiel unterscheidet sich von dem in Figur 2 beschriebenen Ausführungsbeispiel dadurch, dass diese aus mehreren Heizelementen 30a-30d bestehende Heizeinrichtung 30 aufweist, um den Behälter 2 zu beheizen, und um sicherzustellen, dass die Flüssigkeit oder das Gemisch aus Reagenzien auf eine Temperatur erwärmt wird, bei der die zur Beschichtung gewünschte chemische Reaktion stattfinden kann. Figur 3 weist ferner eine zwischen der Ausbringposition 14 und der Einbringposition 12 angeordnete Einrichtung zum Zirkulieren der Flüssigkeit 40 auf, um die aus der Ausbringposition 14, d.h. aus dem Überlauf austretende Flüssigkeit, zumindest teilweise, wieder zu verwenden.

Die Einrichtung zum Zirkulieren der Flüssigkeit 40 weist eine Kühleinrichtung 42 und eine Filtereinrichtung 44 auf, die entlang einer Rückführrichtung 46 sequentiell hintereinander angeordnet sind. Die Kühleinrichtung dient dazu, das Chemikalien- bzw. Reagenzgemisch zu kühlen, um dieses wieder unterhalb eine zur Reaktion erforderliche Temperatur zu bringen, so dass während der Rezirkulation kein Chemikalienverbrauch stattfindet. Bereits reagiertes, beispielsweise kristallisiertes, Material wird mittels des Filters 40 aus den rezirkulierten bzw. recycelten Chemikalien- bzw. Flüssigkeitsstrom entfernt.

Somit ist es, zusätzlich zur Minimierung des Chemikalienverbrauchs durch eine Verringerung des Reaktorvolumens, möglich, den Gesamtverbrauch an Chemikalien bzw. Flüssigkeit zu verringern, indem die Flüssigkeit wieder aufbereitet und erneut verwendet wird. Bei dem in Figur 3 beschriebenen Ausführungsbeispiel kann bei einigen Ausführungsbeispielen die Chemikalie bzw. die Flüssigkeit permanent gekühlt und rezirkuliert werden. Bei kristallinen oder festen Bestandteilen in dem rezirkulierten Flüssigkeitsgemisch (beispielsweise CdS) kann die Flüssigkeit mit einer Zentrifuge gereinigt werden, um die CdS-Partikel/Kolloide abzuscheiden. Selbstverständlich kann alternativ zu dem in Figur 3 gezeigten Ausführungsbeispiel die Reaktorbeheizung auch von innen erfolgen, wobei die Heizelemente 30a-30d beispielsweise auch in den Behälter 2 integriert sein können. Erfindungrgemäß ist zusätzlich, wie in den vorhergehenden Ausführungsbeispielen beschrieben, die Transportrolle 3 beheizt.

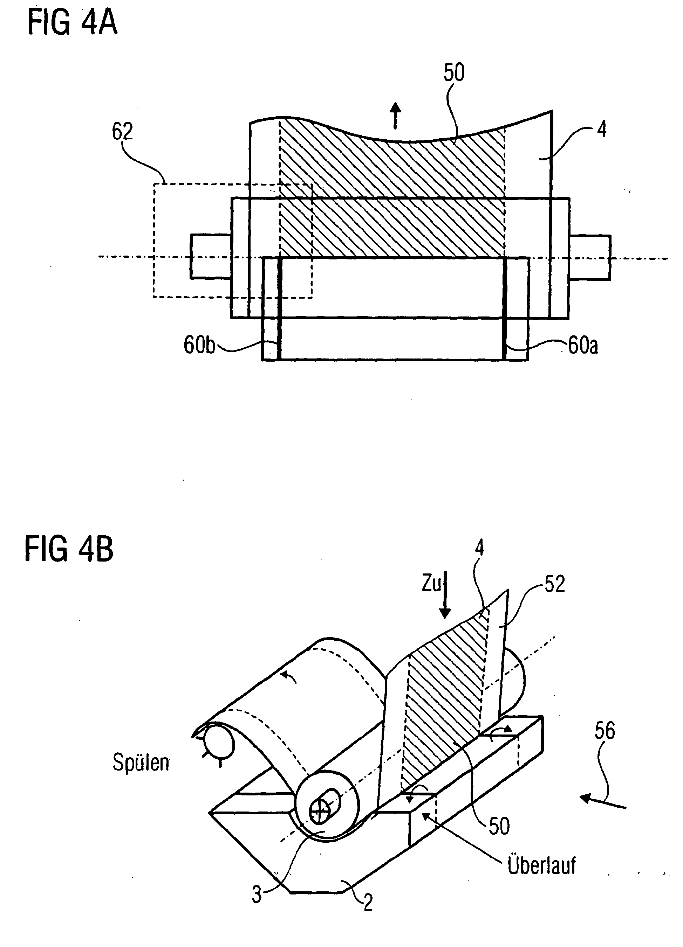

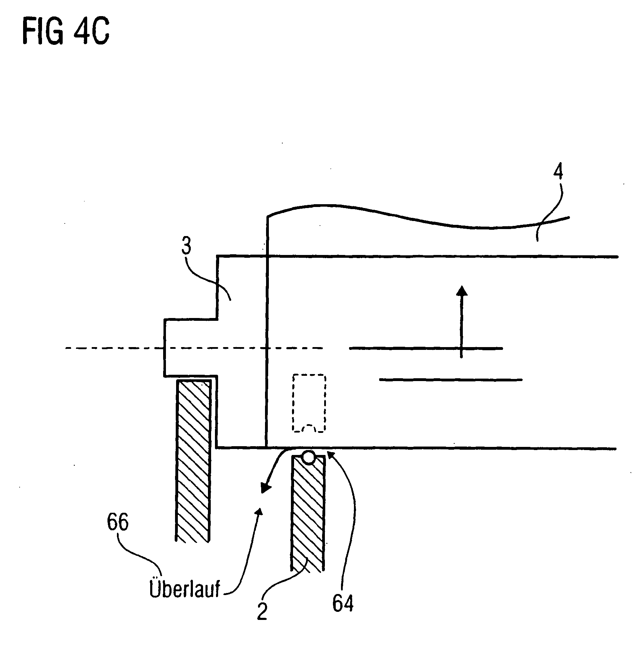

Die Figuren 4a-4c zeigen in verschiedenen Ansichten ein Ausführungsbeispiel der vorliegenden Erfindung, bei dem der Oberflächenbereich des Gutes 4, der mit der Flüssigkeit in Kontakt gebracht wird, begrenzt ist, indem Dichtelemente 64 vorgesehen sind, die die Flüssigkeit von dem nicht in Kontakt zu bringenden Oberflächenbereich des Gutes 4 trennen. Dabei zeigt Figur 4a eine Ansicht des Ausführungsbeispiels, welches in Figur 4b in einer perspektivischen Ansicht dargestellt ist. In Figur 4c ist ferner eine Ausschnittsvergrößerung dargestellt, die es ermöglicht, die Dichtmechanismen zu erkennen, mittels derer der Oberflächenbereich, der mit der Flüssigkeit in Kontakt gebracht wird, begrenzt wird.

Das in den Figuren 4a-4c gezeigte Ausführungsbeispiel basiert dabei auf den bereits anhand der vorhergehenden Figuren diskutierten Ausführungsbeispielen, so dass in der folgenden Diskussion lediglich auf die Änderungen bezüglich dieser Ausführungsbeispiele eingegangen werden wird. Das in Figur 4 zu beschichtende Gut 4 wird derart transportiert bzw. bewegt, dass dieses einen zentralen Bereich 50 sowie einen Randbereich 52 aufweist, wobei lediglich der zentrale Bereich 50 mit der Flüssigkeit in Kontakt gebracht wird. Somit ist der zentrale Bereich 50 derjenige Oberflächenbereich des Gutes 4, der beschichtet wird. Die Flüssigkeit befindet sich in dem Behälter 2, innerhalb dessen die Transportrolle 3 verläuft. Um sicherzustellen, dass die Flüssigkeit lediglich im zentralen Bereich 50 mit dem Gut 4 in Kontakt kommt, ist eine Abdichtung vorgesehen, um das Gut 4 bzw. die Folie 4 zum Behälter 2 abzudichten.

In der in Figur 4 in einer Ansichtrichtung 56 dargestellten Ansicht des Ausführungsbeispiels der Figur 4b ist ersichtlich, dass die an Dichtungspositionen 60a und 60b angebrachten Dichtungen das Gut 4 bzw. die zu beschichtende Folie 4 in den zentralen Bereich 50 und den Randbereich 52 unterteilen. In dem zentralen Bereich 50 wird die Flüssigkeit mit der Oberfläche des Gutes 4 in Kontakt gebracht, wohingegen in dem Randbereich 52 die Oberfläche des Gutes nicht mit der Flüssigkeit bzw. dem Chemikaliengemisch in Kontakt gebracht wird. In der Ausschnittsvergrößerung des in Figur 4a umrahmten Bereichs 62, der in Figur 4c dargestellt ist, wird beispielhaft eine mögliche Form der Abdichtung gezeigt.

Dabei ist zwischen dem auf der Transportrolle 3 laufenden Gut 4 und dem Innenvolumen des Behälters 2, dessen eine Seitenwand schematisch dargestellt ist, ein Dichtmittel 64 angebracht, das ein freies Austreten der Flüssigkeit aus dem Inneren des Behälters 2 verhindert. Die Abdichtung kann dabei beispielsweise mittels einer Lippendichtung aus flexiblen Materialien, wie beispielsweise Kautschuk, CPDM oder Silikon vorgenommen werden. Alternativ dazu kann die Abdichtung auch mit beliebig anderen Dichtmitteln erfolgen, beispielsweise mittels eines Druckluftstroms, dessen Strömungsgeschwindigkeit derart groß ist, dass ein Austreten großer Mengen von Flüssigkeit verhindert werden kann. Bei alternativen Ausführungsbeispielen kann die Passung, also der Abstand zwischen Transportrolle und Behälter 2 so exakt erfolgt sein, dass sich bei Vorhandensein der Folie eine so geringe Spaltbreite ergibt, dass ein Flüssigkeitsaustritt nahezu vollständig verhindert wird. Dennoch austretende Flüssigkeit kann beispielsweise in einem Überlauf 66 aufgefangen werden, um diese eventuell einem Recycling zuzuführen. Weitere Ausführungsbeispiele können einen Gleitring bzw. eine Gleitring-Dichtung aus Kunststoff oder ähnlichen Materialien verwenden. Bei Verwenden von Kunststoff kann die gesamte Vorrichtung mit säurehaltigen Materialien gespült und gereinigt werden, wie beispielsweise mit HCl.

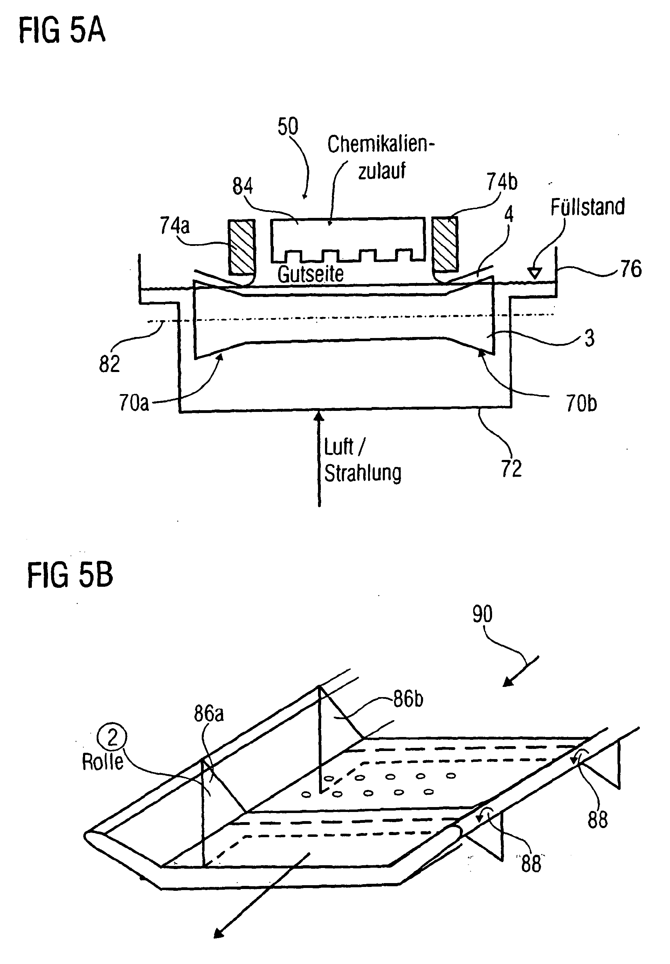

Die in den Figuren 5a und 5b gezeigten Beispiels sind keine Ausführungsbeispiele der Erfindung und zeigen jeweils Vorrichtungen zur Beschichtung einer Oberfläche mit linearem Vorschub, bei dem das Gut 4 näherungsweise eben bzw. plan relativ zur Flüssigkeit bewegt wird, so dass auch nicht flexible Materialien bzw. Materialien mit geringerer Flexibilität ein- oder zweiseitig beschichtet werden können. Bei dem in Figur 5a schematisch in einer Schnittansicht gezeigten Ausführungsbeispiel weist die Transporteinrichtung eine Transportrolle 3 auf, auf der das zu beschichtende Gut 4 läuft und die von einer idealen Zylindergeometrie abweicht und an ihren äußeren Randbereichen 70a, 70b einen sich vergrößernden Durchmesser besitzt. Dadurch wird das Material von der Transportrolle 3 in Form einer Rinne geführt. Die Transportrolle 3 befindet sich in dem in Figur 5a gezeigten Ausführungsbeispiel teilweise innerhalb eines Heizvolumens 72, das mit einer geeigneten Heizmethode (beispielsweise mit Heißluft oder (Infrarot-)Strahlung beheizt werden kann. Die zu beschichtende Oberfläche bzw. die Gutseite des Guts 4 ist der Transportrolle 3 abgewandt und wird in einem zentralen Bereich 50 mit der Flüssigkeit bzw. dem Chemikaliengemisch in Kontakt gebracht und mittels der rotierenden Transportrolle 3 relativ zu dieser bewegt bzw. an dieser vorbeigeführt. Das in Figur 5a gezeigte Ausführungsbeispiel eignet sich für die einseitige Beschichtung eines Gutes bzw. eines bandförmigen Materials, wobei die Chemikalien bzw. die Flüssigkeit zugegeben bzw. zugemischt werden können, wie es bei einem der vorhergehenden Ausführungsbeispiele beschrieben ist. Das Ausführungsbeispiel weist ferner Dichtmittel 74a und 74b auf, um den Oberflächenbereich des Gutes 4, der mit der Flüssigkeit in Kontakt gebracht wird, zu begrenzen. So wird im in Figur 5a gezeigten Ausführungsbeispiel lediglich der zentrale Bereich 50 mit der Flüssigkeit in Kontakt gebracht.

Bei einigen alternativen Ausführungsbeispielen ist ferner die gesamte Apparatur um die Achse 82 gekippt, so dass unter dem Einfluss der Schwerkraft die Flüssigkeit auf der zu beschichtenden Oberfläche im zentralen Bereich 50 über die Oberfläche strömt bzw. fließt, so dass sich sowohl die Flüssigkeit als auch das Gut 4 bewegen. Um eine konstante Strömungsgeschwindigkeit der Flüssigkeit bzw. der Chemikalien zu erzielen, kann optional ein Stromstörer 84 verwendet werden, der innerhalb der Einrichtung zur Bereitstellung der Flüssigkeit, d.h. innerhalb des von den Dichtmitteln 74a und 74b begrenzten Volumens angeordnet ist.

Dabei kann, je nach Anforderung an die Apparatur, die Strömungsrichtung der Flüssigkeit beispielsweise parallel oder antiparallel zu der Vorschubrichtung bzw. der Bewegungsrichtung des Gutes oder der Folie 4 sein.

Figur 5b zeigt in einer perspektivischen Ansicht eine mögliche Implementierung der Transporteinrichtung 3 aus Fig. 5a. Im gezeigten Beispiel besteht diese aus zwei Rollen 86a und 86b, welche in einer Rotationsrichtung 88 rotieren, und somit das Gut in einer Transportrichtung 90 bewegen, so dass dieses beschichtet werden kann, wenn innerhalb der durch die Form der Transportrollen 86a und 86b gebildeten Rinne die zur Beschichtung verwendete Flüssigkeit bzw. das zur Beschichtung verwendete Chemikaliengemisch befindlich ist. Zusätzlich kann mittels eines Luftkissens der Transport unterstützt werden und/oder zusätzlich eine Heizung implementiert werden, wenn die Luft beheizt werden soll.

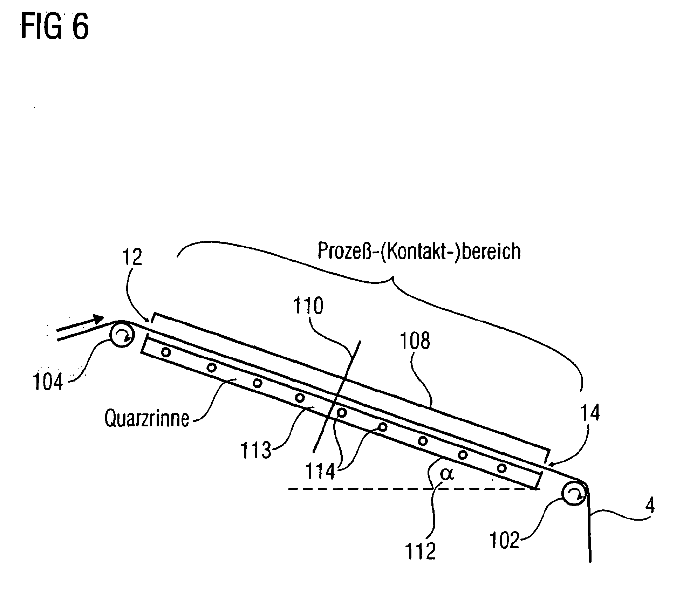

Figur 6, die kein Ausführungsbeispiel der Erfindung zeigt, zeigt ein Beispiel mit linearem Vorschub des Gutes 4, das mittels zweiter Führungsrollen 102 und 104 durch eine Prozessstrecke 108, geführt wird, die dazu dient, die Flüssigkeit bereitzustellen, innerhalb derer also sich die zur Beschichtung verwendete Flüssigkeit befindet. An der Einbringposition 12 werden die Chemikalien oder die Flüssigkeit eingebracht, die an der Ausbringposition 14, also an einem Auslauf, die Einrichtung 108 wieder verlassen.

Bei der in Fig. 6 gezeigten Schnittansicht mit linearem Vorschub kann ein Winkel 112 (α) zwischen der Horizontalen und der Apparatur bzw. dem Prozessbereich variiert werden, um eine Relativgeschwindigkeit zwischen der Flüssigkeit bzw. dem Chemikaliengemisch und dem zu beschichtenden Gut zu variieren. Dabei kann an der Eingangsseite 12 eine Abdichtungsmaßnahme vorgesehen sein, um ein ungewolltes Austreten der Chemikalien entgegen der Richtung der Bewegung des zu bewegenden Gutes zu verhindern. Dies kann beispielsweise mittels eines Luftmessers oder Mittels flexibler Dichtungen erreicht werden. Innerhalb der Prozessstrecke 108 kann das zu transportierende Gut 4 beispielsweise auf einer "Hot-Plate" 113 gelagert bzw. von einer solchen geführt sein, so dass das Gut zusätzlich beheizt werden kann. Bei einigen Ausführungsbeispielen wird die Hot-Plate beheizt. Dies kann beispielsweise durch eine in Kanälen 114 in der Hot-Plate 113 zirkulierende aufgeheizte Flüssigkeit erreicht werden. Bei weiteren Ausführungsbeispielen strömt ein Gas durch Bohrungen der Hot-Plate an die Unterseite des zu führenden Guts 4, so dass dieses auf einem Luftpolster schwebend durch die Prozessstrecke 108 geführt wird. Bei einigen Ausführungsbeispielen ist die in Fig. 6 gezeigte Anordnung bzw. die Prozessstrecke lediglich in Richtung des Winkels 112 rotierbar. Bei weiteren Ausführungsbeispielen kann die Proßessstrecke 108 in allen Raumrichtungen bewegt werden, so dass bei geeigneter Ansteuerung eine Taumelbewegung erzeugt wird, die die gleichmäßige Verteilung der Chemikalien auf der Oberfläche des zu beschichtenden Gutes sicherstellt. Damit kann insbesondere die Homogenität der Beschichtung verbessert werden. Bei weiteren Ausführungsbeispielen sind zusätzliche Durchmischungseinrichtungen angebracht, die sicherstellen, dass das Chemikaliengemisch permanent homogen durchmischt bleibt, so dass sich eine gleichmäßige Beschichtung ergibt. Bei einigen Ausführungsbeispielen der vorliegenden Erfindung wird dies durch einen oder mehrerer Ultraschallsender erreicht, die ein Ultraschallsignal in die Flüssigkeit abstrahlen, so dass die Molekülbewegung innerhalb der Flüssigkeit verstärkt wird und dadurch die Homogenität der Durchmischung verbessert wird.

Alternativ und/oder zusätzlich kann, wie bereits anhand einiger im Vorhergehenden diskutierter Ausführungsbeispiele erläutert, die Chemikalienmischung bzw. die Flüssigkeit permanent aufgefrischt bzw. regeneriert werden. Dies erfordert einen Austausch der Flüssigkeit auf der Oberfläche des zu transportierenden Gutes. Zu diesem Zweck kann die Flüssigkeit entweder in Transportrichtung des Gutes oder entgegen der Transportrichtung des Gutes geführt werden.

Wie bei den übrigen Ausführungsbeispielen ist es wünschenswert, dass die Materialien, die verwendet werden, um die mit dem zu transportierenden Gut in direktem Kontakt stehenden Bauteile zu bilden, resistent gegen die Verwendung der Chemikalien und gegen die auftretenden Temperaturen sind. Daher können die Materialien näherungsweise frei gewählt werden und an die verwendeten Chemikalien bzw. Prozesstemperaturen angepasst werden. Beispielsweise können die Materialien innerhalb der Prozessstrecke 108 bzw. der Transporttrommel 3 der vorhergehenden Ausführungsbeispiele aus Quarzglas oder VA-Stahl bestehen. Weitere mögliche Werkstoffe sind Kunststoffe und Metalle bzw. Metalllegierungen. Von Vorteil ist es, wenn diese mittels einer Säure gereinigt werden können, ohne zerstört zu werden.

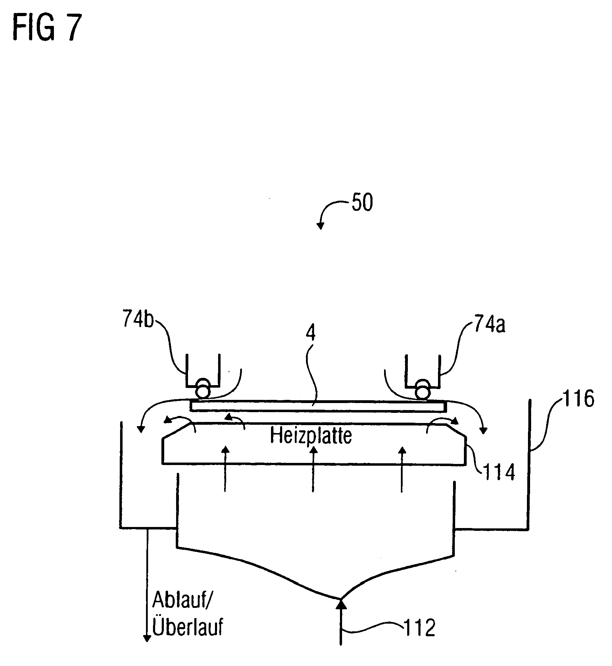

Figur 7 zeigt einen Schnitt durch die in Figur 6 gezeigte Vorrichtung entlang einer Schnittebene 110. Das zu beschichtende Gut bzw. Material wird in einem zentralen Bereich 50 mit einer auf dem Gut 4 strömenden Flüssigkeit in Kontakt gebracht, wobei Dichtmittel 74a und 74b verhindern, dass ein signifikanter Bruchteil der Flüssigkeit den zentralen Bereich 50 verlassen kann. Bei einigen Ausführungsbeispielen wird ein Luftkissen zwischen einer sogenannten "Hot-plate" 114 und dem Gut erzeugt, auf dem das Gut transportiert wird. Bei weiteren Ausführungsbeispielen wird die im Luftstrom befindliche "Hot-plate" 114, die mit Bohrungen versehen ist und aus einem massiven Material besteht, beheizt, so dass die Luft von der "Hot-plate" 114 aufgeheizt wird und durch die Bohrungen ferner ermöglicht wird, dass sich zwischen der Hot-plate 114 und dem Gut 4 ein Luftfilm bildet. Durch das Verwenden der Hot-plate 114 kann auch eine Durchbiegung des Gutes 4 verhindert werden und es kann sichergestellt werden, dass die Temperatur näherungsweise konstant ist, wenn ein Material für die Hot-plate verwendet wird, welches eine hohe Wärmekapazität besitzt. Ein möglicherweise über die Dichtmittel 74a und 74b austretende Chemikaliengemisch bzw. eine austretende Flüssigkeit kann mittels eines Überlaufbeckens 116 aufgefangen und eventuell recycled werden.

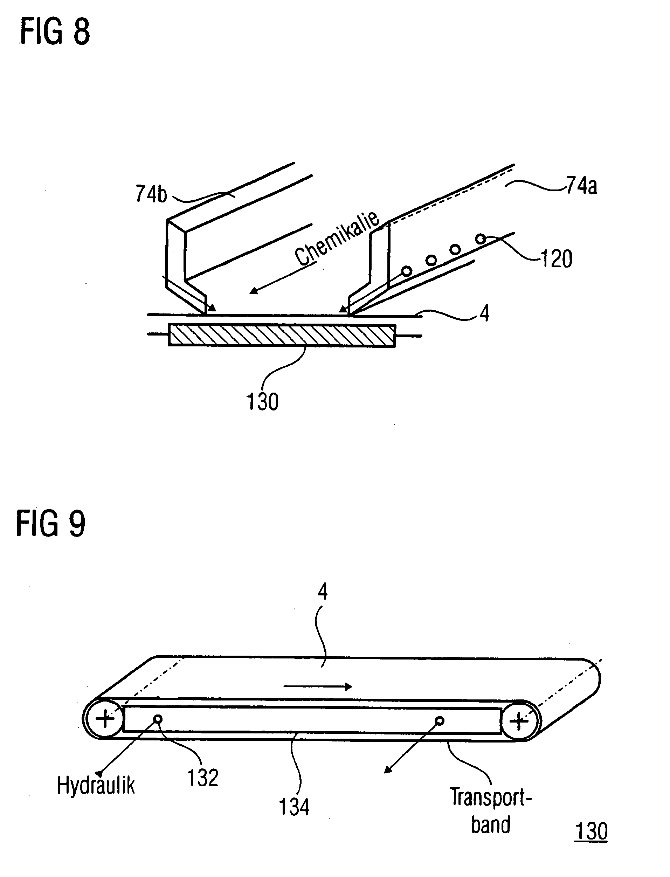

Figur 8 zeigt ein nicht erfindungsgemäßen Ausführungsbeispiel mit linearer Führung des Gutes 4, bei dem die Dichtmittel 74a und 74b so ausgebildet sind, dass die Dichtwirkung durch einen Luftstrom erzielt wird. Zu diesem Zweck können, wie in Figur 8 gezeigt, die das Flüssigkeitsvolumen begrenzenden Seitenwände mit Luftbohrungen 120 versehen sein, durch die Luft oder ein beliebiges anderes Gasgemisch, das zur Dichtung verwendet werden kann, strömt. Die Strömungsgeschwindigkeit der Luft muss geeignet gewählt sein, so dass diese ermöglicht, ein Austreten der Flüssigkeit bzw. der Chemikalien an den Rändern der Dichtelemente 74a und 74b zu verhindern. Zur Heizung des Gutes 4 bzw. des zu beschichtenden Materials kann ferner eine Hot-plate verwendet werden, auf der, wie in Figur 9 schematisch dargestellt, ein Transportband verlaufen kann, welches wiederum den Transport des zu beschichtenden Gutes 4 sicherstellt, also die Transporteinrichtung bildet.

Figur 9 zeigt ein nicht erfindungsgemäßen Ausführungsbeispiel eines solchen Transportbandes, bei dem sich im Inneren eine beispielsweise mittels einer Flüssigkeit durch Flüssigkeitskanäle 132 beheizte Hot-plate 134 befindet. Zwischen der Hot-plate 134 und dem zu transportierenden Gut 4, das im vorliegenden Fall in Form eines bandförmigen Materials vorliegt, befindet sich ein Luftkissen, mittels dessen das Gut 4 sowohl beheizt wird als auch vor mechanischer Beschädigung geschützt und mit ausreichendem Druck gegen die Dichtmittel 74a und 74b gepresst wird.

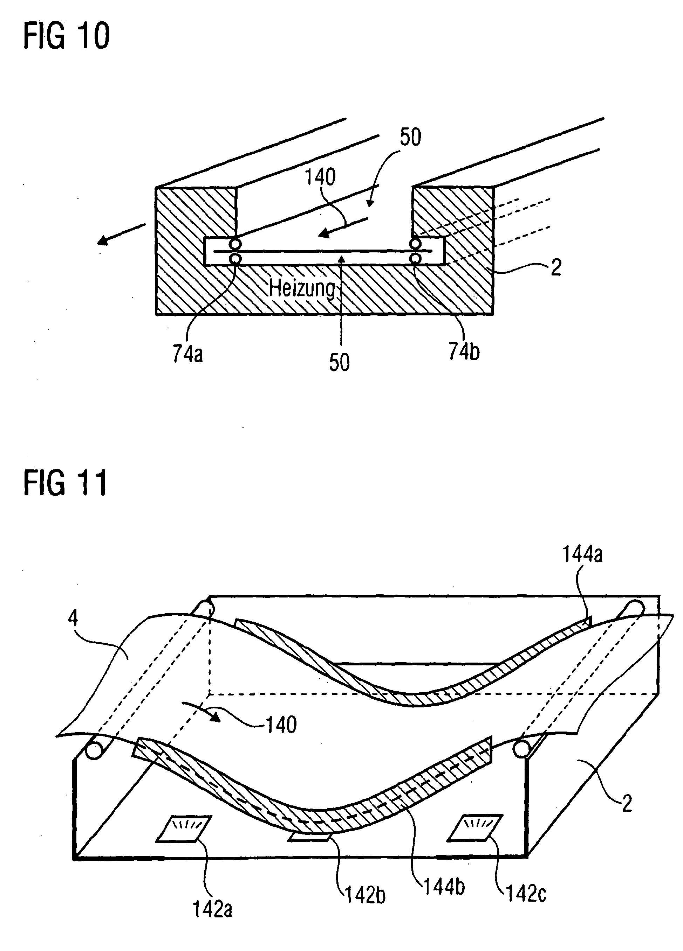

Die Figuren 10 und 11 zeigen nicht erfindungsgemäße, mittels derer ein beidseitiges Beschichten eines Gutes 4 ermöglicht wird, wobei die beschichtete Oberfläche jeweils durch geeignete Dichtmittel 74a und 74b begrenzt wird, so dass die Transporteinrichtung die zu beschichtende Oberfläche lediglich in einem zentralen Bereich 50 in Kontakt mit der Flüssigkeit bringt.

Bei dem in Figur 10 gezeigten Ausführungsbeispiel wird das Gut bzw. das bandförmige Material 4 in einer Bewegungsrichtung 140 relativ zum Behälter 2 bewegt, innerhalb dessen sich die Flüssigkeit befindet. Das zu beschichtende Gut 4 wird dabei von Dichtlippen bzw. Dichtmitteln 74a und 74b sowohl mechanisch geführt als auch bezüglich des Behälters 2 abgedichtet, so dass eine sich in dem zentralen Bereich 50 befindliche Flüssigkeit bzw. eine dort eingebrachte Flüssigkeit zur Beschichtung diesen Bereich nicht verlassen kann, so dass auf jeder der beiden zu beschichtenden Oberflächenseiten lediglich ein begrenzter Oberflächenbereich, nämlich der zentrale Bereich 50, beschichtet bzw. mit der Flüssigkeit in Kontakt gebracht wird.

Der in Figur 11 gezeigte Fall entspricht prinzipiell dem in Figur 10 diskutierten Ausführungsbeispiel, wobei auch hier die Bewegungsrichtung 140 parallel zur Längsrichtung des Gutes bzw. des Materials ist. Der Förderweg ist jedoch nicht eben, sondern gekrümmt, so dass eine Abdichtung des Behälters 2 selbst unterbleiben kann, da das Gut entlang der Förderrichtung 140 zunächst in das innerhalb des Behälters 2 befindliche Flüssigkeitsvolumen getaucht und, aufgrund des krummen Förderwegs, aus diesem wieder entfernt wird.

Dies ermöglicht es, ohne aufwendige Dichtungsmaßnahmen beidseitig Materialien zu beschichten, welche die erforderliche Flexibilität für den gekrümmten Förderweg aufweisen.

Fig. 11 zeigt ferner optionale Ultraschallsender 142a, 142b und 142c, die innerhalb des Prozessvolumens 2 befindlich und mit diesem derart gekoppelt sind, dass diese Ultraschallleistungen die Flüssigkeit einstrahlen können. Dies dient dazu, die Homogenität der Durchmischung der Einzelkomponenten der Flüssigkeit zu verbessern, was insgesamt zu einer homogeneren Beschichtung des Guts bzw. der Folie führt.

Das zu beschichtende Gut 4 wird im in Fig. 11 gezeigten Fall von Führungsschienen 144a und 144b seitlich geführt, um den Förderweg einhalten zu können.

Selbstverständlich ist auch in Fig. 11 eine einseitige Beschichtung eines Gutes möglich, sofern die Führungsschienen 144a und 144b die bereits weiter oben beschriebenen Dichtungsmaßnahmen aufweisen, so dass eine Flüssigkeit beispielsweise nur oberhalb des zu beschichtenden Gutes 4 befindlich sein kann, und nur die Oberseite des Gutes 4 beschichtet wird.

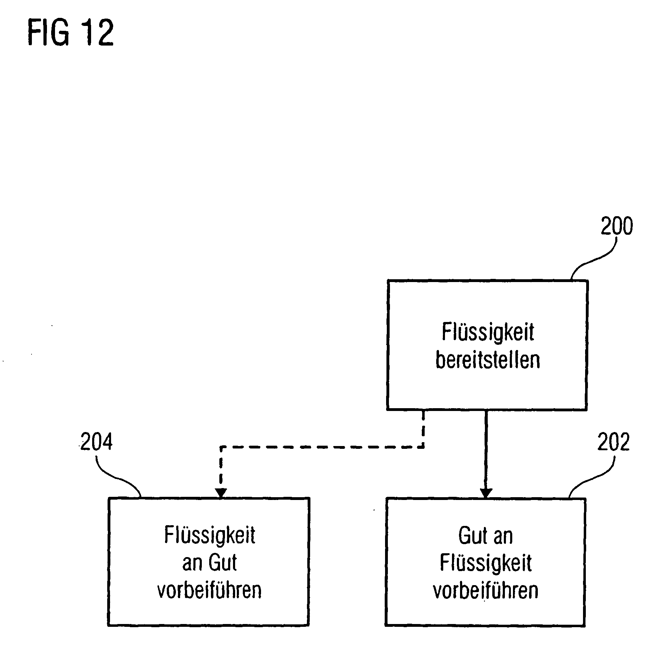

Figur 12 zeigt ein Ausführungsbeispiel für ein Verfahren zum Beschichten einer Oberfläche eines Gutes.

Zunächst wird in einem Bereitstellungsschritt 200 eine Flüssigkeit bereitgestellt, welche die zur Beschichtung erforderlichen Reagenzien aufweist. In einem Vorschubschritt 202 wird eine zu beschichtende Oberfläche des Gutes mit der Flüssigkeit in Kontakt gebracht und an derselben vorbeigeführt, so dass die zu beschichtende Oberfläche für eine bestimmte Zeit mit der Flüssigkeit in Kontakt bleibt.

Durch das Vorbeiführen, bzw. die relative Bewegung zu dem zu beschichtenden Material bzw. Gut ist gewährleistet, dass eine kontinuierliche Beschichtung stattfinden kann, auch wenn Materialien beschichtet werden sollen, die in einer lateralen Richtung eine sehr große Ausdehnung besitzen, also beispielsweise bandförmig sind.

Bei einem anhand von Fig. 12 ebenfalls dargestellten alternativen und nicht erfindungsgemäßen Verfahren wird nach dem Bereitstellungsschritt 200 in einem Schritt 204 die Flüssigkeit am feststehenden Gut vorbeigeführt. Dies kann beispielsweise dazu verwendet werden, in einem diskreten Betrieb nicht kontinuierliche Materialien zu beschichten, wie beispielsweise Kunststoffplatten oder Glassubstrate oder Ähnliches.

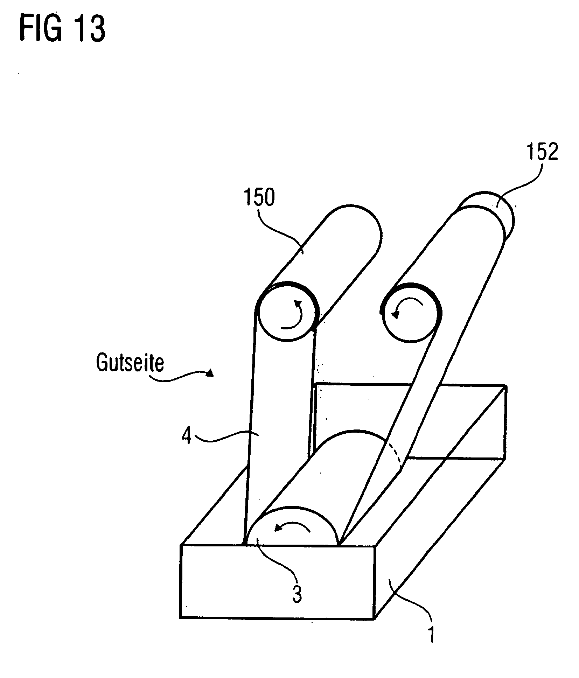

Figur 13 zeigt ein Ausführungsbeispiel eines Systems zur Beschichtung eines bahnförmigen Gutes. Das in Figur 13 schematisch dargestellte System umfasst eine Vorrichtung zur Beschichtung einer Oberfläche 1, die einem der vorhergehenden ausführlich diskutierten Ausführungsbeispiele entsprechen kann, und die geeignet ist, eine Oberfläche eines Gutes 4 zu beschichten. Das System weist ferner eine Vorratsrolle 150 auf, die dazu dient, das zu beschichtende Gut zu bevorraten und das Gut für die Transporteinrichtung der Vorrichtung zur Beschichtung eines Gutes 1 bereitzustellen. Ferner weist das System eine Entnahmerolle 152 auf, um das beschichtete Gut von der Transporteinrichtung zu empfangen und um das beschichtete Gut zu bevorraten. Da es die erfindungsgemäßen Ausführungsbeispiele der Vorrichtungen zur Beschichtung einer Oberfläche eines Gutes erlauben, das Gut kontinuierlich an der zu beschichtenden Flüssigkeit vorbeizuführen, ist es mit dem in Figur 13 gezeigten System möglich, Materialien von "Rolle-zu-Rolle" zu beschichten, diese also kontinuierlich zu beschichten, ohne das Material in diskrete Stücke zerteilen zu müssen. Dies erhöht die Effizienz der Beschichtung und verringern die Beschichtungskosten signifikant.

Wie es in Fig. 13 dargestellt ist, ist es dabei günstig, ein Auf- und Abrollen des zu beschichtenden Guts auf der Vorratsrolle 150 bzw. auf der Entnahmerolle 152 so durchzuführen, dass die zu beschichtende Seite des Guts 4 (die Gut-Seite) jeweils auf den Durchmessern der Rollen nach außen zeigt. Dadurch wird zusätzliche Zeit zur Trocknung der Chemikalie an der Oberfläche der Gutseite 4 gewonnen, wenn diese an der Entnahmerolle 152 aufgerollt wird. Zusätzlich wird vermieden, dass die Gutseite, also die zu beschichtende Seite, in mechanischen Kontakt mit anderen Führungs- oder Umlenkrollen kommen kann, wenn eine Geometrie verwendet wird, wie sie in Fig. 13 gezeigt ist.

Mögliche weitere Umlenkrollen sind bei weiteren Ausführungsbeispielen der Erfindung vorgesehen. Sofern die Umlenkrollen die Gutseite berühren, verfügen diese bei einigen Ausführungsbeispielen entweder über eine Vorrichtung, um einen Flüssigkeitsfilm auf der Oberfläche der Umlenkrolle bereitzustellen oder um ein Luftpolster, auf dem das Gut schweben kann, zu erzeugen.

So wird, selbst wenn eine Umlenkung in Richtung der Gutseite aus prozesstechnischen Gründen erforderlich wird, vermieden, dass die beschichtete Folie bzw. das beschichtete Gut qualitativ verschlechtert wird.

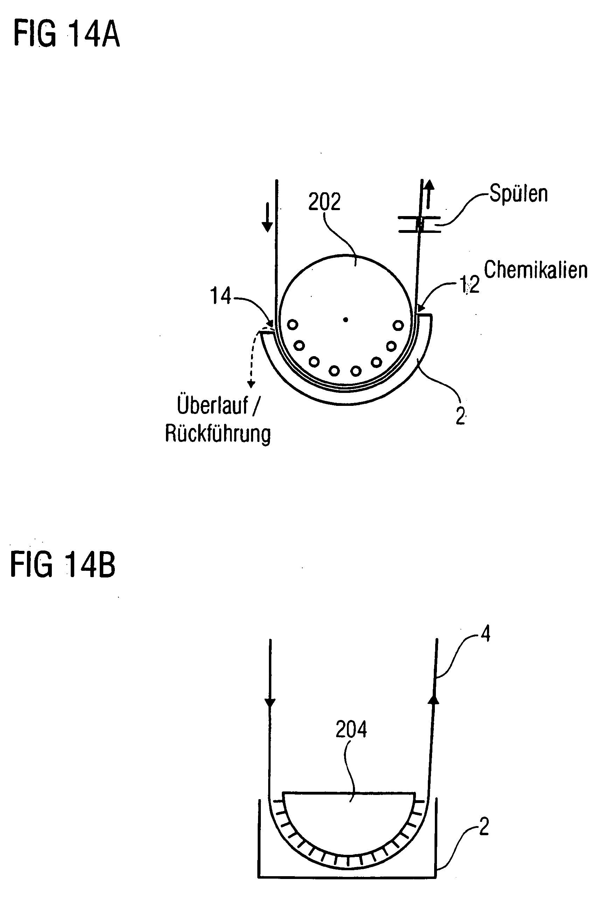

Figuren 14a und 14b zeigen kein Ausführungsbeispiel der Erfindung. Es wird, wie anhand der Figuren 1 bis 4 bereits diskutiert, das zu beschichtende Gut 4 um einen zylinderförmigen Körper 202 bzw. um ein Kreisbogensegment 204 geführt. Alternativ zum in den Figuren 1 bis 4 diskutierten Fall, in welchem die Trommel, um die das Gut 4 geführt wird, rotiert, ist es bei den in den Figuren 14a und 14b gezeigten Ausführungsbeispielen ferner möglich, dass die Trommel bzw. das Kreisbogensegment 204 starr angeordnet sind. Die übrigen Komponenten entsprechen den in den Figuren 1 bis 4 bereits diskutierten Komponenten, so dass auf eine erneute Diskussion dieser Teile an dieser Stelle verzichtet wird.

Mit anderen Worten bewegt sich bei den in den Figuren 14a und 14b gezeigten Ausführungsbeispielen lediglich das zu beschichtende Gut 4, die Trommel 202 bzw. das Kreisbogensegment 204 dient lediglich der Definition des Weges. Bei einigen Ausführungsbeispielen ist, um eine reibungslose Relativbewegung des zu beschichtenden Guts 4 zur Trommel 202 bzw. zum Kreisbogensegment 204 sicherzustellen, sowohl die Trommel 202 als auch das Kreisbogensegment 204 mit Bohrungen versehen, die es ermöglichen, ein mit Überdruck in der Trommel 202 bzw. dem Kreisbogensegment 204 befindliches Gas bzw. eine innerhalb der Komponenten befindliche Flüssigkeit austreten zu lassen, so dass das zu beschichtende Gut 4 auf einem Gas oder Flüssigkeitsfilm gleiten kann. Als Gas kann dabei beispielsweise $N_2$ oder Druckluft verwendet werden. Wird das Gas bzw. die Druckluft ferner geheizt, kann die Prozessgeschwindigkeit an der Oberfläche des zu beschichtenden Guts 4 erhöht werden bzw. es kann ein Prozess erst ermöglicht werden, falls dieser endotherm ist. Mit anderen Worten arbeitet das Gas zum einen als Transportmittel und zum anderen als Schutz bzw. Rückseitenprotektor für die der Flüssigkeit abgewandten Oberfläche des zu beschichtenden Guts 4. Dadurch wird ein einseitiges Beschichten ohne Randausschuss möglich, wenn der Luftdruck so groß ist, dass dieser an den Rändern des zu beschichtenden Gutes 4 verhindert, dass Flüssigkeit zwischen die Rückseite des zu beschichtenden Gutes und die Trommel 202 des Kreisbogensegments 204 gerät.

Die in Fig. 14a und 14b gezeigten Geometrien zur Führung des zu beschichtenden Guts 4 sind lediglich exemplarisch. Bei weiteren Ausführungsbeispielen werden daher unterschiedliche Geometrien des den Weg definierenden Elements (der Trommel 202 des Kreisbogensegments 204 bzw. der alternativen Ausführungsform) verwendet. Insbesondere kommen Elemente mit nicht-konstanter Krümmung, wie beispielsweise Ellipsoide oder dergleichen in Betracht. Auch bei diesen Ausführungsbeispielen ist es von Vorteil, wenn das Material, aus dem die Trommel gebildet ist, temperatur- und/oder säurebeständig ist, so dass die Apparatur leicht mittels Säure gereinigt werden kann bzw. bei andauernd hoher Prozesstemperatur keinen Schaden nimmt. Wie bereits oben diskutiert kommen hier beispielsweise Quarzglas oder PTFE als Materialien infrage, ohne dass diese Beispiele als abschließende Liste zu verstehen sein sollen.

Obwohl in den vorhergehenden Ausführungsbeispielen hauptsächlich Folien oder flexible Substrate beschichtet wurden, ist die Anwendung des beschriebenen Konzepts nicht auf solche Materialien beschränkt. Vielmehr können, insbesondere mit den Ausführungsbeispielen mit linearem Vorschub, auch nicht flexible Materialien beschichtet werden, wie beispielsweise Glas-Substrate, Halbleiter-Substrate oder sonstige mono- oder polykristalline Substrate und dergleichen Materialien.

Insofern eine schnelle Trocknung oder vollständige Trocknung der Beschichtung vor der Aufwicklung oder Weiterverarbeitung des beschichteten Gutes nicht ohne externe Maßnahmen erreicht werden kann, können weitere Ausführungsbeispiele zusätzlich eine Trockeneinrichtung aufweisen, mittels derer die Beschichtung auf der Oberfläche des zu beschichtenden Gutes getrocknet wird, bevor dieses weiterverarbeitet wird.

Die anhand der vorhergehenden Ausführungsbeispiele diskutierten Geometrien der ansprechenden Vorrichtungen sind lediglich beispielhaft zu verstehen und können beliebig an die Gegebenheiten angepasst werden, solange sichergestellt ist, dass das zu beschichtende Gut an der Flüssigkeit vorbeigeführt bzw. relativ zur Flüssigkeit bewegt wird.

Zusätzlich kann, wenn Umlenkrollen mit einem Wasserfilm oder Vakuumschlitten beziehungsweise Komponenten mit Luftpolster verwendet werden, ein zu transportierendes Band oder Gut ohne Berührung der Beschichtung annähernd beliebig umgelenkt werden. Werden die Rollen vorausgelenkt beziehungsweise mit vorbestimmter Kraft gegen das zu transportierende Gut gedrückt, kann darüber hinaus eine für einen faltenfreien Transport eines bandförmigen Materials erforderliche Bandspannung aufrechterhalten werden.

**Patentansprüche**

1. Vorrichtung zur Beschichtung einer Oberfläche eines Gutes mit folgenden Merkmalen:

   einer Einrichtung zum Bereitstellen einer Flüssigkeit (2), die zur Beschichtung erforderliche Reagenzien aufweist;
   einer Transporteinrichtung (3), die ausgebildet ist, um eine Relativbewegung zwischen einer zu beschichtenden Oberfläche des Gutes (4) und der Flüssigkeit zu bewirken, während die zu beschichtende Oberfläche des Gutes mit der Flüssigkeit in Kontakt ist, so dass die zu beschichtende Oberfläche für eine vorbestimmte Zeit mit der Flüssigkeit in Kontakt bleibt, um eine Beschichtung derselben zu bewirken, wobei die Transporteinrichtung (3) ferner ausgebildet ist, um die Relativbewegung tangential zu der zu beschichtenden Oberfläche, kontinuierlich und ohne Umkehr der Bewegungsrichtung (5) zu bewirken;
   einer Heizeinrichtung (30; 80), die ausgebildet ist, um die zu beschichtende Oberfläche, während die zu beschichtende Oberfläche des Gutes mit der Flüssigkeit in Kontakt ist, auf eine Temperatur zu heizen, bei der eine Reaktion der Reagenzien, durch die die Beschichtung bewirkt wird, stattfindet;
   wobei die Heizeinrichtung (30; 80) ausgebildet ist,
   um eine rotierende Transportrolle (3) der Transporteinrichtung zu beheizen, die auf der der Flüssigkeit gegenüberliegenden Seite des Gutes (4) angeordnet ist, um die Relativbewegung zu bewirken; und
   wobei die Vorrichtung ausgelegt ist, um ein bandförmiges Gut (4) einseitig zu beschichten.

2. Vorrichtung nach Anspruch 1, die ferner Dichtmittel (60a, 60b; 74a, 74b) aufweist, die ausgelegt sind, um den Oberflächenbereich (50) des Gutes, der mit der Flüssigkeit in Kontakt gebracht wird, zu begrenzen.

3. Vorrichtung nach Anspruch 2, bei der die Dichtmittel (60a, 60b; 74a, 74b) eine Lippendichtung, eine Gleitringdichtung oder eine Druckluft-Dichtung aufweisen.

4. Vorrichtung gemäß einem der vorhergehenden Ansprüche, bei der die Einrichtung zum Bereitstellen einer Flüssigkeit ferner eine Durchmischungseinrichtung aufweist, um eine Homogenität der Beschichtung des Gutes zu verbessern und/oder eine Einrichtung zum Erneuern und/oder Aufbereiten und/oder Zirkulieren der Flüssigkeit (40) aufweist.

5. Vorrichtung nach einem der Ansprüche 1 bis 4, bei der die Einrichtung zum Bereitstellen der Flüssigkeit einen Behälter (2) mit einer inneren Oberfläche aufweist, die der zu beschichtenden Oberfläche des Gutes (4) gegenüberliegt und deren Form an eine Form der zu beschichtenden Oberfläche des Gutes (4) angepasst ist.

6. Vorrichtung nach einem der vorhergehenden Ansprüche, bei der die Transporteinrichtung ausgebildet ist, um auf einer der Flüssigkeit abgewandten Seite des Gutes dieses auf einer Transportschicht eines Gases oder einer Flüssigkeit zu führen.

7. Vorrichtung nach einem der Ansprüche 1 bis 6, bei der die Einrichtung zum Bereitstellen (2) der Flüssigkeit eine Einbringposition (12) und eine von der Einbringposition (12) beabstandete Ausbringposition (14) für die Flüssigkeit aufweist, wobei die Transporteinrichtung (3) ausgebildet ist, um das Gut (4) von der Ausbringposition (14) der Flüssigkeit zu der Einbringposition (12) durch die Einrichtung zum Bereitstellen der Flüssigkeit zu transportieren.

8. Vorrichtung nach einem der Ansprüche 1 bis 7, die eine Führungsrolle (6) aufweist, die ausgebildet ist, um einen Wasserfilm auf einer Oberfläche derselben bereitzustellen, um eine beschichtete Oberfläche des Gutes (4) zu führen.

9. Vorrichtung nach einem der Ansprüche 1 bis 8, bei der die Transporteinrichtung ausgelegt ist, um das Gut (4) mit einer konstanten Geschwindigkeit zu bewegen, während die zu beschichtende Oberfläche mit der Flüssigkeit in Kontakt ist.

10. Vorrichtung nach einem der Ansprüche 1 bis 9, die ferner eine Trockeneinrichtung aufweist, um ein beschichtetes Gut (4) zu trocknen, sodass eine Beschichtung der zu beschichtenden Oberfläche getrocknet wird.

11. Verfahren zum einseitigen Beschichten einer Oberfläche eines bandförmigen Gutes mit folgenden Schritten:

   Bereitstellen einer Flüssigkeit, die zur Beschichtung erforderliche Reagenzien aufweist; und in Kontakt bringen des Gutes und der Flüssigkeit und erzeugen einer Relativbewegung zwischen einer zu beschichtenden Oberfläche des Gutes (4) und der Flüssigkeit, während die zu beschichtende Oberfläche des Gutes mit der Flüssigkeit in Kontakt ist, so dass die zu beschichtende Oberfläche für eine vorbestimmte Zeit mit der Flüssigkeit in Kontakt bleibt, um eine Beschichtung derselben zu bewirken, wobei die Relativbewegung tangential zu der zu beschichtenden Oberfläche, kontinuierlich und ohne Umkehr der Bewegungsrichtung (5) bewirkt wird; und während die zu beschichtende Oberfläche des Gutes mit der Flüssigkeit in Kontakt ist, beheizen der zu beschichtenden Oberfläche auf eine Temperatur, bei der eine Reaktion der Reagenzien, durch die die Beschichtung bewirkt wird, stattfindet, indem eine rotierende Transportrolle (3) beheizt wird, die auf der der Flüssigkeit gegenüberliegenden Seite des Gutes (4) angeordnet ist, um die Relativbewegung zu bewirken.

12. Verfahren nach Anspruch 11 , bei dem das Gut mit einer konstanten Geschwindigkeit bewegt wird, während die zu beschichtende Oberfläche mit der Flüssigkeit in Kontakt ist.

13. Verfahren nach einem der Ansprüche 11 oder 12, das ferner ein Begrenzen des Oberflächenbereichs des Gutes, der mit der Flüssigkeit in Kontakt gebracht wird, aufweist.

14. Verfahren nach einem der Ansprüche 11 bis 13, bei dem das Gut eine Kunststofffolie oder eine Metallfolie ist, und bei dem die Oberfläche des Gutes mit CdS beschichtet wird.

15. System zum Beschichten eines bahnförmigen Gutes mit folgenden Merkmalen:

   einer Vorrichtung (1) zur Beschichtung einer Oberfläche eines Gutes gemäß einem der Ansprüche 1 bis 10; einer Vorratsrolle (150) zum Bevorraten des zu beschichtenden Gutes (4) und zum Bereitstellen des Gutes (4) für die Transporteinrichtung (3); und einer Entnahmerolle (152) zum Empfangen des beschichteten Gutes von der Transporteinrichtung (3) und zum Bevorraten des beschichteten Gutes.

**Claims**

1. A device for coating a surface of a product, comprising:

   means for providing a liquid (2) comprising reagents required for coating; and transport means (3) implemented to effect a relative movement between a surface of the product (4) to be coated and the liquid while the surface of the product to be coated is in contact with the liquid such that the surface to be coated remains in contact with the liquid for a predetermined period of time so as to cause coating thereof, the transport means (3) further being implemented to effect the relative movement tangentially to the surface to be coated, continuously and without reversing the direction of movement (5); heating means (30; 80) implemented to heat the surface to be coated to a temperature where reaction of the reagents by which coating is effected takes place, while the surface of the product to be coated is in contact with the liquid; the heating means (30; 80) being implemented to heat a rotating transport roller (3) of the transport means arranged on the side of the product (4) opposite to the liquid in order to effect the relative motion, and wherein the device is implemented to coat a band-shaped product (4) on one side.

2. The device in accordance with claim 1, further comprising sealing agents (60a, 60b; 74a, 74b) configured to limit the surface region (50) of the product which is contacted by the liquid.

3. The device in accordance with claim 2, wherein the sealing agents (60a, 60b; 74a, 74b) comprise lip sealing, slip ring sealing or compressed air sealing.

4. The device in accordance with one of the preceding claims, wherein the means for providing a liquid additionally comprises intermixing means in order to improve the homogeneity of the coating of the product and/or means for regenerating and/or treating and/or circulating the liquid (40).

5. The device in accordance with one of claims 1 to 4, wherein the means for providing the liquid comprises a container (2) having an internal surface which is opposite the surface of the product (4) to be coated and the shape of which is adapted to a shape of the surface of the product (4) to be coated.

6. The device in accordance with one of the preceding claims, wherein the transport means is configured to guide the product, on a side of the product facing away from the liquid, on a gas or liquid transport layer.

7. The device in accordance with one of claims 1 to 6, wherein the means for providing (2) the liquid comprises an introduction position (12) and a discharge position (14) for the liquid spaced apart from the introduction position (12), the transport means (3) being implemented to transport the product (4) through the means for providing the liquid from the discharge position (14) of the liquid to the introduction position (12).

8. The device in accordance with one of claims 1 to 7, comprising a guiding roller (6) implemented to provide a film of water on a surface thereof so as to guide a coated surface of the product (4).

9. The device in accordance with one of claims 1 to 8, wherein the transport means is configured to move the product (4) at a constant rate, while the surface to be coated is contacted by the liquid.

10. The device in accordance with one of claims 1 to 9, further comprising drying means for drying a coated product (4) so that a coating of the surface to be coated is dried.

11. A method for one-sided coating of a surface of a band-shaped product, comprising:

providing a liquid comprising reagents required for coating; and

contacting the product and the liquid and generating a relative movement between a surface of the product (4) to be coated and the liquid, while the surface of the product to be coated is contacted by the liquid such that the surface to be coated remains in contact with the liquid for a predetermined period of time so as to effect coating thereof, the relative movement being effected tangentially to the surface to be coated, continuously and without reversing the direction of movement (5), and

while the surface of the product to be coated is contacted by the liquid, heating the surface to be coated to a temperature where the reagents by which coating is effected react, by heating a rotating transport roller (3) arranged on the side of the product (4) opposite to the liquid in order to effect the relative motion.

12. The method in accordance with claim 11, wherein the product is moved at a constant rate while the surface to be coated is in contact with the liquid.

13. The method in accordance with claims 11 or 12, further comprising limiting the surface region of the product which is contacted by the liquid.

14. The method in accordance with one of claims 11 to 13, wherein the product is a plastic foil or a metal foil and wherein the surface of the product is coated by CdS.

15. A system for coating a web-shaped product, comprising:

a device (1) for coating a surface of a product in accordance with one of claims 1 to 10;
a storage roller (150) for storing the product (4) to be coated and for providing the product (4) to the transport means (3); and
a withdrawal roller (152) for receiving the coated product from the transport means (3) and for storing the coated product.

**Revendications**

1. Dispositif pour appliquer un revêtement sur une surface d'un produit, aux caractéristiques suivantes:

un moyen pour préparer un liquide (2) présentant les réactifs nécessaires pour le revêtement;
un moyen de transport (3) qui est réalisé pour provoquer un déplacement relatif entre une surface à revêtir du produit (4) et le liquide tandis que la surface à revêtir du produit est en contact avec le liquide, de sorte que la surface à revêtir reste pendant un temps prédéterminé en contact avec le liquide, pour provoquer un revêtement de celle-ci, le moyen de transport (3) étant par ailleurs réalisé pour provoquer le déplacement relatif tangentiellement à la surface à revêtir, en continu et sans inversion du sens de déplacement (5);

un moyen de chauffage (30; 80) qui est réalisé pour chauffer la surface à revêtir, tandis que la surface à revêtir du produit est en contact avec le liquide, à une température à laquelle a lieu une réaction des réactifs par laquelle est provoqué le revêtement;

le moyen de chauffage (30; 80) étant réalisé pour chauffer un rouleau de transport rotatif (3) du moyen de transport qui est disposé du côté du produit (4) opposé au liquide, pour provoquer le déplacement relatif; et

le dispositif étant réalisé pour revêtir d'un côté un produit en forme de bande (4).

2. Dispositif selon la revendication 1, présentant par ailleurs des moyens d'étanchéité (60a, 60b; 74a, 74b) qui sont réalisés pour limiter la zone de surface (50) du produit qui est amenée en contact avec le liquide.

3. Dispositif selon la revendication 2, dans lequel le moyen d'étanchéité (60a, 60b; 74a, 74b) présente un joint d'étanchéité à lèvres, un joint d'étanchéité à bague coulissante ou un joint d'étanchéité à air comprimé.

4. Dispositif selon l'une des revendications précédentes, dans lequel le moyen pour préparer un liquide présente par ailleurs un moyen de mélange, pour améliorer une homogénéité du revêtement du produit et/ou un moyen pour renouveler et/ou préparer et/ou faire circuler le liquide (40).

5. Dispositif selon l'une des revendications 1 à 4, dans lequel le moyen pour préparer le liquide présente un récipient (2) avec une surface intérieure qui se trouve opposée à la surface à revêtir du produit (4) et dont la forme est adaptée à une forme de la surface à revêtir du produit (4).

6. Dispositif selon l'une des revendications précédentes, dans lequel le moyen de transport est réalisé pour amener le fluide, d'un côté du produit éloigné du liquide, sur une couche de transport d'un gaz ou d'un liquide.

7. Dispositif selon l'une des revendications 1 à 6, dans lequel le moyen pour préparer (2) le liquide présente une position d'entrée (12) et une position de sortie (14) du liquide distante de la position d'entrée (12), le moyen de transport (3) étant réalisé pour transporter le produit (4) de la position de sortie (14) du fluide à la position d'entrée (12) à travers le moyen pour préparer le liquide.

8. Dispositif selon l'une des revendications 1 à 7, présentant un rouleau de guidage (6) qui est réalisé pour préparer un film d'eau sur une surface de ce dernier, pour guider une surface revêtue du produit (4).

9. Dispositif selon l'une des revendications 1 à 8, dans lequel le moyen de transport est réalisé pour déplacer le produit (4) à une vitesse constante, tandis que la surface à revêtir est en contact avec le liquide.

10. Dispositif selon l'une des revendications 1 à 9, présentant par ailleurs un moyen de séchage, pour sécher un produit revêtu (4), de sorte que soit séché un revêtement de la surface à revêtir.

11. Procédé pour appliquer un revêtement sur un surface d'un côté d'un produit en forme de bande, aux étapes suivantes consistant à:

préparer un liquide présentant des réactifs nécessaires pour le revêtement; et

amener le produit et le liquide en contact et générer un déplacement relatif entre une surface à revêtir du produit (4) et le liquide, tandis que la surface à revêtir du produit est en contact avec le liquide, de sorte que la surface à revêtir reste pendant un temps prédéterminé en contact avec le liquide, pour provoquer un revêtement de celle-ci, le déplacement relatif étant provoqué tangentiellement à la surface à revêtir, en continu et sans inversion du sens de déplacement (5); et

tandis que la surface à revêtir du produit est en contact avec le liquide, chauffer la surface à revêtir à une température à laquelle a lieu une réaction des réactifs par laquelle est provoqué le revêtement, en chauffant un rouleau de transport rotatif (3) qui est disposé du côté du produit (4) opposé au liquide, pour provoquer le déplacement relatif.

12. Procédé selon la revendication 11, dans lequel le produit est déplacé à une vitesse constante tandis que la surface à revêtir est en contact avec le liquide.

13. Procédé selon l'une des revendications 11 ou 12, présentant par ailleurs une limitation de la zone de surface du produit qui est amenée en contact avec le liquide.

14. Procédé selon l'une des revendications 11 à 13, dans lequel le produit est un film plastique ou un film métallique, et dans lequel la surface du produit est revêtue de CdS.

**15.** Système pour appliquer un revêtement sur un produit en forme de bande, aux caractéristiques suivantes:

un dispositif (1) pour appliquer un revêtement sur une surface d'un produit selon l'une des revendications 1 à 10;
un rouleau d'alimentation (150) pour l'alimentation du produit à revêtir (4) et pour préparer le produit (4) pour le moyen de transport (3); et
un rouleau de prélèvement (152) destiné à recevoir le produit revêtu du moyen de transport (3) et pour alimenter le produit revêtu.

# FIG 1

FIG 2

EP 2 217 385 B1

# FIG 3

EP 2 217 385 B1

FIG 4A

50

62

4

60b 60a

FIG 4B

4

Zu

52

Spülen

56

50

3 2

Überlauf

# FIG 4C

## FIG 5A

## FIG 5B

FIG 6

Prozeß-(Kontakt-)bereich

12

110

108

104

Quarzrinne

113

114

α

14

112

102

4

# FIG 7

## FIG 8

## FIG 9

## FIG 10

Heizung

50
140
2
74a
50
74b

## FIG 11

144a
4
140
2
142a
142b
144b
142c

# FIG 12

200

Flüssigkeit
bereitstellen

204

Flüssigkeit
an Gut
vorbeiführen

202

Gut an
Flüssigkeit
vorbeiführen

FIG 13

150

152

Gutseite

4

3

1

## FIG 14A

## FIG 14B

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- GB 1206106 A
- US 5795625 A
- US 3762190 A
- EP 0038084 A
- EP 0608192 A1
- US 3863600 A